# DEMANDE DE BREVET EUROPEEN

(11) **EP 1 788 497 A1**
(43) Date de publication de la demande: **23.05.2007**
(21) Numéro de dépôt: 05300943.7
(22) Date de dépôt: 18.11.2005
(51) Int. Cl.: G06F 17/50, G06F 9/44

(54) **Motif de conception et procédé de transformation d'un modèle objet**

(71) Demandeur: Alcatel Lucent, 75008 Paris (FR)
(72) Inventeur: Larvet, Philippe, 91470 Forges les bains (FR); Pastor, Alain, 92100 Boulogne Billancourt (FR)
(74) Mandataire: Sciaux, Edmond

(57) **Abrégé**

L'invention concerne un motif de conception (70) adapté à être implémenté informatiquement en une séquence de transformations élémentaires d'un modèle objet (40).

L'invention concerne également un produit de programme d'ordinateur (50), par exemple comprenant un programme d'aide à l'utilisateur, prévu pour interpréter ce motif.

Elle concerne encore un procédé de transformation d'un modèle objet, comprenant : une étape d'accession (E2) audit motif; et une étape d'exécution (E3) de la séquence de transformations élémentaires du modèle objet. Du code peut ensuite être généré simplement, de façon systématique et sans erreurs.

## Description

La présente invention concerne un motif de conception et un procédé de transformation d'un modèle objet.

Dans la présente description, les termes suivants sont employés avec le sens indiqué, sauf mention particulière :
- « classe » : désigne la notion de classe communément manipulée dans les formalismes de modélisation et langages de programmation orientés objet et notamment l'agrégation de données et de traitements (ou attributs et méthodes, respectivement) destinés à fonctionner ensemble dans une application informatique. Dans les langages orientés objet, chaque type d'objet est définie par sa classe. Une classe représente l'ensemble des objets partageant les mêmes attributs, opérations, méthodes, relations et sémantiques.
- « diagramme » : une représentation graphique d'une collection d'éléments de modélisation, montrant par exemple un graphe d'arcs (relations) et des sommets (autres éléments de modélisation). La norme UML propose les diagrammes suivants : diagramme de classes, diagramme d'objets, diagramme de cas d'utilisation, diagramme de séquence, diagramme de collaboration, diagramme d'états transitions, diagramme d'activités, diagramme de composants et diagramme de déploiement.
- « génération de code » : désigne ici la production automatique ou semi-automatique de code source pour une application informatique, au moyen d'un générateur. Elle se fait à partir d'une description abstraite d'une d'application logicielle fournie au générateur et servant à piloter cette génération. Celui-ci, après analyse de cette description, construit le code attendu en sortie. Cette description est généralement exprimée dans un langage de plus haut niveau que celui dans lequel le code sera produit. Ainsi on peut exploiter le générateur sans avoir à connaître le formalisme du langage de programmation utilisé dans le code généré.
- « Model Driven Architecture » (MDA) désigne un ensemble de spécifications de l'OMG, lesquelles ont trait à un processus de développement utilisant une suite de modèles et leurs transformations successives. Ces modèles intègrent plusieurs dimensions du projet et s'étendent du modèle fonctionnel au modèle code source. Ces modèles obéissent au standard UML. La progression d'un modèle à l'autre comprend un enrichissement progressif des spécifications de l'application et utilise des transformations autorisées par le métamodèle UML.
- « modélisation » désigne l'activité de représentation abstraite d'un énoncé, d'un problème ou d'un système, réalisée d'une part dans un but de compréhension et de communication de cette compréhension, et d'autre part dans un but de résolution du problème ou d'implémentation concrète du système.
- « modélisation orientée objet » désigne un type particulier de modélisation dans laquelle les éléments de modélisation sont des classes, objets, attributs, méthodes, associations, etc. ; cela se distingue de la « modélisation fonctionnelle » dans laquelle les éléments de modélisation sont des fonctions de traitement et des flux de données. Voir aussi « UML ».
- « motif de conception » (de l'anglais « design pattern », aussi appelé « patron de conception », « patron de conception réutilisable ») désigne une façon standardisée de résoudre un problème connu, par exemple un problème récurrent d'architecture ou de conception de logiciels. Un motif de conception est une description abstraite d'une solution technique à un problème donné et récurrent de conception. Par exemple : comment contrôler la persistance d'objets ? ; Comment contrôler des interfaces graphiques ? ; Comment commander l'exécution de code ? ; Comment mettre en application une machine d'état ?, etc. Des motifs de conception ont par exemple été publiés dans un ouvrage de référence célèbre: « Design Patterns, Elements of Reusable Object-Oriented Software », Erich Gamma & al., Addison-Wesley, Reading, MA, 1995. Un tel motif se distingue d'un algorithme, lequel décrit formellement comment résoudre le problème ; il est en outre très souvent indépendant de tout langage de programmation. La description d'un tel motif suit généralement un formalisme fixe :
   - Nom
   - Description du problème à résoudre
   - Description de la solution : les éléments de la solutions, avec leurs relations.
   - Conséquences : résultats issus de la solution.
- « OMG » (pour « Object Management Group »), désigne une organisation dont l'un des buts est de définir des standards afin de garantir la compatibilité entre des applications programmées à l'aide de langages orientés objet (*cf.* http://www.omg.org).
- « objet » : désigne, en modélisation ou en programmation orientée objet, une instance de classe, constitué d'un ensemble de données (les propres données définitoires de la classe) et des procédures utiles à leur manipulation.
- « orienté objet », se dit par exemple d'un modèle, d'un langage, d'une application ou d'éléments d'applications dont les constituants sont des classes et des objets. Par exemple un langage orienté objet est un langage de programmation dans lequel les composants de base sont des classes, dont les instances - les objets - vivent dynamiquement dans le programme informatique qui les utilise.
- « stéréotype » (stereotype), désigne un type d'élément de modélisation qui étend la sémantique du métamodèle. Les stéréotypes doivent être basés sur certains types ou classes existants dans le métamodèle. Les stéréotypes peuvent étendre la sémantique, mais pas la structure des types et des classes préexistants. Certains stéréotypes sont prédéfinis dans le langage UML, d'autres peuvent être définis par l'utilisateur. Les stéréotypes constituent, avec les "tagged values" et les "annotations", un des trois mécanismes d'extension du langage UML.
- « UML » (Unified Modeling Language, que l'on peut traduire par «langage de modélisation unifié) : désigne une notation (plutôt qu'un langage) de modélisation par objets, permettant de déterminer et de présenter les composants d'un système objet lors de son développement, ainsi que, le cas échéant, d'en générer la documentation. UML est actuellement la norme OMG. Il résulte de la fusion des travaux de Jim Rumbaugh, Grady Booch et Ivar Jacobson et connaît de nombreuses évolutions. La notation UML, telle qu'elle est actuellement normalisée, propose une représentation graphique pour différents diagrammes (voir ci-dessus).

On connaît la modélisation dite « modélisation objet », qui consiste à créer une représentation d'éléments du monde réel en termes de classes et d'objets, indépendamment de tout langage de programmation. Par exemple, des classes d'objets sont déterminées, leurs données propres et les fonctions qui les utilisent sont isolées. Divers formalismes existent. UML est l'un de ces formalismes (il s'agît en fait plutôt d'un catalogue de notations).

Les langages orientés objet possèdent chacun une manière spécifique d'implémenter le concept de classe. En particulier, un formalisme ou une méthode objet permet de définir un problème à « haut niveau d'abstraction» sans rentrer dans les spécificités d'un langage donné. Par exemple, UML offre un outil permettant aisément de représenter un problème de façon graphique, le rendant plus accessible aux différents acteurs intervenant dans sa résolution.

Typiquement, il est tout d'abord procédé à la production d'un modèle objet abstrait, par exemple en vue de la résolution d'un problème donné.
La production du modèle objet abstrait se fait généralement en plusieurs étapes. Lorsqu'on développe une application informatique orientée-objet, on procède souvent par transformation de modèles. On manipule ainsi plusieurs modèles, qui sont des modèles objet :
- d'abord, le "modèle d'analyse" (ou "modèle métier", ou "modèle du problème") ;
- ensuite, le "modèle d'architecture" (modèle des divers éléments technologiques qui seront utilisés pour construire la solution) ;
- en croisant le modèle d'analyse avec les exigences d'architecture, on obtient le "modèle de conception" (ou "modèle de la solution") ; il est au départ "général", puis on lui applique différents "motifs de conception", ce qui en fait un "modèle de conception détaillé" ;
- ce modèle est alors prêt pour produire le code final (que l'on peut appeler "modèle d'implémentation").

Ensuite, il est procédé à l'implémentation de ce modèle à l'aide d'un langage orienté objet (tel que le langage C# ou Java). Il est donc souhaitable qu'un formalisme objet soit défini le plus rigoureusement possible, de préférence qu'il soit unique et ce, afin de restreindre au maximum les ambiguïtés.

Un problème qui se pose dans le cadre d'un développement de projet logiciel avec Java, C++ or C#, par exemple selon les spécifications MDA, est d'appliquer correctement un motif de conception (par exemple un motif issu de l'ouvrage de référence cité ci-dessous mais pas seulement) à un modèle, par exemple un modèle UML, et incidemment de générer correctement un code correspondant.

La solution courante à ce problème est d'appliquer manuellement le motif au modèle UML représentant la conception de l'application envisagée, afin de transformer ce modèle en un nouveau modèle UML détaillé, à partir duquel du code peut ensuite être produit.

Cette solution n'est cependant pas satisfaisante parce qu'elle est manuelle. Elle est donc lente et susceptible d'occasionner des erreurs. En outre, elle peut donner lieu à des contradictions dans le modèle final. De surcroît, elle nécessite d'appliquer les motifs un par un.

II existe donc un besoin pour un motif de conception et un procédé de transformation d'un modèle objet qui permettent de transformer un modèle objet en un nouveau modèle objet sans occasionner d'erreur ni de contradictions dans le modèle. De plus, ce motif de conception devrait être conçu de telle sorte qu'il permette une application plus efficace de plusieurs motifs similaires.

A cette fin, l'invention propose un motif de conception adapté à être implémenté informatiquement en une séquence de transformations élémentaires d'un modèle objet, et qui est caractérisé en ce que chacune des transformations élémentaires est une modification, une suppression ou une création d'un élément de modélisation du modèle objet.

Dans des modes de réalisation préférés, le motif de conception selon l'invention comprend en outre une ou plusieurs des caractéristiques suivantes :
- le modèle objet est conforme à la notation UML;
- le motif est interprétable par un programme informatique et le motif est prévu pour déclencher l'exécution par ce programme de la séquence de transformations ; et
- le programme informatique comporte un programme d'aide à l'utilisateur;

L'invention concerne également un produit de programme d'ordinateur, par exemple comprenant un programme d'aide à l'utilisateur, prévu pour interpréter le motif de conception selon l'invention.

L'invention propose en outre un procédé de transformation d'un modèle objet, comprenant une étape d'accession au motif de conception selon l'invention et une étape d'exécution de la séquence, prévue par ce motif, de transformations élémentaires d'un modèle objet initial.

Dans des modes de réalisation préférés, le procédé de transformation d'un modèle objet selon l'invention comprend une ou plusieurs des caractéristiques suivantes :
- le procédé de transformation d'un modèle objet comprend préalablement : une étape d'accession au modèle objet initial, celui-ci comprenant plusieurs éléments de modélisation ; pour chaque élément de modélisation du modèle objet initial, une étape de recherche d'un stéréotype associé ; et si un stéréotype a été trouvé à l'étape de recherche, une étape de recherche du motif de conception correspondant au stéréotype trouvé;
- le procédé de transformation d'un modèle objet comprend préalablement : une étape de sauvegarde du modèle objet initial ; et
- certaines au moins des étapes du procédé de transformation d'un modèle objet selon l'invention sont effectuées par un programme d'aide à l'utilisateur.

L'invention concerne en outre un procédé de génération de code, comprenant les étapes du procédé de transformation d'un modèle objet selon l'invention ; et une étape de génération d'un code à partir du modèle objet transformé à l'étape d'exécution de la séquence de transformations.

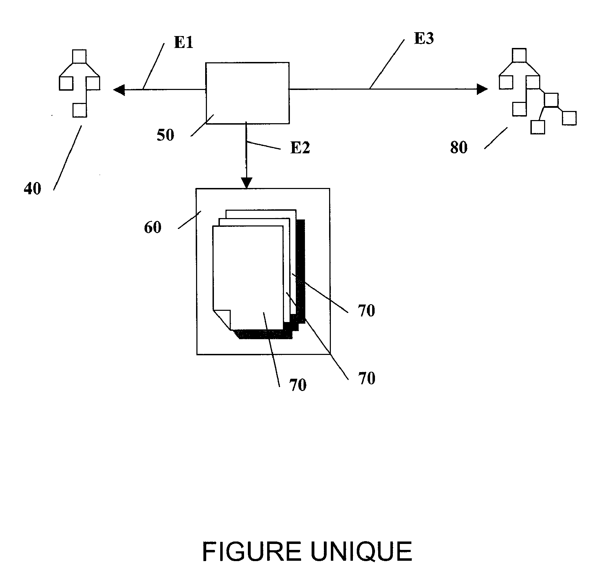

D'autres caractéristiques et avantages de l'invention apparaîtront à la lecture de la description détaillée qui suit des modes de réalisation de l'invention, donnés à titre d'exemple uniquement et en références à des exemples, ainsi qu'au schéma annexé, qui illustre (figure unique) des étapes et composantes du procédé selon un mode de réalisation de l'invention.

L'idée de base de l'invention re-conceptualise le motif de conception ; le motif de conception est au sens de l'invention conçu de telle sorte qu'il peut être implémenté informatiquement sous la forme d'une séquence de transformations élémentaires d'un modèle objet.

Ce motif comporte typiquement un identifiant correspondant à un stéréotype donné, pour pouvoir être retrouvé.

Une transformation élémentaire donnée, par exemple une modification, une suppression ou une création d'un élément de modélisation donné du modèle objet, peut ainsi être facilement et systématiquement réalisée par un outil informatique adapté. En outre, une séquence donnée de transformations élémentaires peut être trouvée pour un problème résolu abstraitement par un motif de conception tel qu'on l'entend au sens classique (c'est-à-dire tel que défini plus haut). Ainsi, implémenter un motif de conception en une séquence de transformations élémentaires d'un modèle objet permet de faire évoluer ce modèle objet vers un modèle détaillé, lequel permet ensuite éventuellement une conversion systématique en un code (génération de code).

Plus spécifiquement, un motif de conception au sens de l'invention peut être décrit par une structure de donnée (par exemple un fichier informatique) telle que, lorsqu'elle est accédée puis interprétée par un programme, elle déclenche l'exécution de la séquence, prévue par ce motif, de transformations élémentaires du modèle objet. On implémente ainsi des procédures spécifiques permettant d'appliquer automatiquement des motifs de conception à un modèle.

Le formalisme de modélisation est typiquement la notation UML ; auquel cas les éléments de modélisation sont les éléments classiquement manipulés par UML, c'est-à-dire des paquetages, classes, attributs, opérations, associations, cardinalités, héritages, etc.

La figure unique illustre des étapes et composantes du procédé selon un mode de réalisation de l'invention.

La figure représente schématiquement un modèle objet initial 40 (par exemple un modèle UML), un modèle final détaillé 80, un répertoire (c'est-à-dire un « catalogue de motifs») 60 comprenant une pluralité de motifs 70 de conception (au sens de l'invention) et un programme 50, comprenant par exemple un programme d'aide à l'utilisateur ou assistant. Le modèle initial 40 est un modèle général, c'est-à-dire tel qu'il apparaît à un moment de la conception du modèle, avant que ce modèle n'ait un niveau de détail suffisant pour permettre une génération de code.

Le catalogue est accessible par le programme d'aide à l'utilisateur et les motifs 70 de conception qu'il contient sont interprétables par ce programme. Le cas échéant, le programme d'aide à l'utilisateur est interfacé avec un outil de modélisation, tel que Rational Rose® de IBM, Objecteering® de Softeam ou Rhapsody® de i-Logix. De la sorte, l'outil de modélisation est piloté par le programme d'aide à l'utilisateur et effectue des tâches telles qu'une transformation élémentaire ou la conversion d'un modèle UML en un code. Dans ce cas, le programme d'aide à l'utilisateur et l'outil de modélisation peuvent être considérés comme formant l'entité de programme 50.

Le procédé selon l'invention comprend, le cas échéant, une étape d'accession au modèle objet initial 40 de l'application visée par le développeur. Ce modèle initial comporte plusieurs éléments de modélisation (c'est-à-dire, des "atomes" de modèle, selon la notation standard UML). Un modèle comprend des "éléments de modélisation", par exemple un package, un attribut ou l'opération d'une classe sont de tels éléments. Le modèle initial 40 peut être analysé (étape El), c'est-à-dire que pour chaque "élément" du modèle objet initial, il est effectué une étape de recherche d'un stéréotype associé. Ensuite, si un stéréotype a été trouvé à l'étape de recherche, il est effectué une étape de recherche d'un motif de conception 70 correspondant au stéréotype trouvé (étape E2).

En pratique, le programme d'aide à l'utilisateur offre au développeur la possibilité de choisir, dans le modèle UML initial de son application, l'élément de modélisation (ou l'ensemble d'éléments) auquel appliquer un motif de conception donné. Pour ce faire, avant d'exécuter le programme, le modèle original 40 est "marqué", c'est-à-dire que chaque élément du modèle auquel on veut appliquer un motif de conception est noté avec un stéréotype spécifique dont l'étiquette (le label) est le nom du motif. Le programme est ainsi de préférence conçu comme un outil d'assistance convivial, notamment adapté aux mesures préparatoires décrites ci-dessus.

Ensuite, le développeur lance l'exécution du ou des motifs 70 : pour ce faire, le programme d'aide à l'utilisateur peut par exemple accéder au catalogue 60 et sélectionner le ou les motif(s) 70 à exécuter. Le motif 70 approprié comporte alors un identifiant correspondant au stéréotype trouvé, à cet effet.

Le programme peut de préférence sauvegarder une copie du modèle 40 initial afin de permettre une annulation ou un retour (commande « undo »), en cas d'erreur quelconque.

Les séquences de transformations prévues par un motif 70 sélectionné sont typiquement réalisées par le biais de l'outil de modélisation, sous la forme de scripts exécutables interfacés avec ces outils par le programme d'aide à l'utilisateur. Par exemple, le programme d'aide à l'utilisateur est écrit dans le langage de script proposé par l'environnement UML (par exemple en VBA pour Rational Rose® ou en langage J pour Objecteering®), et les "motifs de conception" sont lus par un module du programme d'aide à l'utilisateur, qui interprète la notation formelle de chaque transformation élémentaire.

Cependant, la notation formelle utilisée pour chaque transformation élémentaire peut demeurer indépendante de l'outil UML. Les motifs eux-mêmes sont donc réutilisables d'un outil UML à l'autre. Un moteur du programme d'aide à l'utilisateur peut, à cet effet, être adapté à l'environnement de chaque outil de modélisation. Dans ce cas, l'entité de programme 50 (soit le programme d'aide à l'utilisateur et l'outil de modélisation) est adaptée à accéder et interpréter le motif pour en exécuter la séquence de transformations élémentaires prévues.

Par exemple, un motif 70 peut être un ensemble de transformations élémentaires, chacune d'elles étant une clause formelle indépendante de tout outil de modélisation spécifique. Il peut, dans ce cas, être prévu un seul script générique (c'est-à-dire le moteur du programme 50) qui lit les motifs 70, les interprète et les exécute).

Une séquence de transformations élémentaires correspond ainsi à un motif 70. Une séquence sélectionnée par le programme d'aide à l'utilisateur est alors communiquée à un "moteur" spécifique du programme 50 qui interprète et exécute la séquence de transformation (étape E3), appliquée au modèle objet présent en mémoire dans l'outil de modélisation. L'exécution de cette séquence transforme pas à pas le modèle original 40 en un nouveau modèle 80 plus détaillé. Chaque motif de conception 70 (par exemple: « Singleton », « Factory », « Proxy », « Iterator », « State », etc., voir l'ouvrage de référence cité) est implémenté sous la forme d'une séquence de transformations élémentaires. Chaque transformation occasionne un changement élémentaire du modèle 40, par exemple: l'ajout d'un attribut, la création d'une classe, la mention du type d'un attribut, l'ajout d'une association, etc. Une transformation élémentaire est ainsi un « quantum d'action ». Chaque quantum correspond à une action indépendante, laquelle est par exemple prise en charge par l'outil de modélisation, isolément. Ceci peut être obtenu par le biais de l'appel d'une primitive spécifique, conforme au méta-modèle implémenté dans l'outil de modélisation (par exemple : « ajouter attribut », « renommer association », « créer package », etc.). Une séquence d'actions spécifique résout un problème spécifique (selon le motif de conception). Ainsi, à chaque motif 70 correspond une procédure, automatiquement applicable au modèle UML 40 implémenté dans l'outil de modélisation. Plusieurs séquences peuvent en outre être implémentées de façon successive et systématique par le même procédé informatique, étant donné qu'elles ont la même structure logique (séquence de « quantum d'action » de même plan logique), sans donner lieu à des incohérences.

L'application de séquence(s) de transformations élémentaires au modèle initial 40 produit un modèle détaillé 80. Le modèle détaillé 80 permet ensuite la génération automatique du code correspondant, à partir d'une représentation interne propriétaire de l'outil de modélisation utilisé. Il convient de noter que c'est également sur cette représentation interne propriétaire que peuvent être effectuées les primitives élémentaires de transformation du modèle.

Le code généré est par exemple du code Java, C++ ou C#. Pour effectuer la génération de code, le programme d'aide à l'utilisateur peut par exemple instruire en ce sens l'outil de modélisation, qui est muni d'un générateur de code. C'est par exemple le cas avec l'outil de modélisation Rational Rose.

Par exemple, considérons le cas d'un modèle 40 de conception auquel nous voulons appliquer les motifs suivants, par exemple le motif « State » (« Etat ») sur trois classes du modèle 40, le modèle « Singleton » (« Singleton » en français) sur quatre classes et le modèle « Iterator » (« Itérateur » en français) sur deux classes. Dans cet exemple, trois classes d'état du modèle sont marquées avec le stéréotype « State », quatre classes Singleton sont marquées avec le stéréotype « Singleton » et les deux classes « Iterator » avec le stéréotype correspondant. Après marquage du modèle, le programme 50 exécutera les étapes suivantes:
- copie du modèle 40 original dans le modèle détaillé ;
- pour chaque classe du modèle 40 original :
   - analyse de la classe et recherche d'un stéréotype ;
   - si un stéréotype est trouvé :
      - recherche dans le catalogue 60 du motif 70 correspondant à ce stéréotype ;
      - lancement de l'exécution de ce motif 70 (ce qui crée, modifie ou supprime des éléments de modélisation dans le modèle détaillé 80) ;
   - fin du test « si » ;
- fin de la boucle « pour chaque classe du modèle 40 original »
- // à cette étape, un nouveau modèle détaillé 80 de conception est construit ;
- génération du code à partir du modèle détaillé de conception

Le procédé décrit ci-dessus assure une transformation systématique, rapide et sans erreur du modèle initial 40 en un modèle détaillé 80, lequel permet ensuite de générer automatiquement du code. Selon ce procédé, une pluralité de motifs de conception peut être appliquée suite à une seule instruction d'exécution par le développeur, ce qui améliore l'efficacité du procédé. Ceci est possible grâce au fait qu'un motif 70 selon l'invention a une structure logique donnée. En outre chaque motif 70 ayant cette même structure logique peut être implémenté à la suite d'un autre motif.

L'invention n'est cependant pas limitée aux variantes décrites ci-avant mais est susceptible de nombreuses autres variations aisément accessibles à l'homme du métier. A titre d'exemple, il est possible d'utiliser le mécanisme décrit ci-dessus, dans son esprit:
- pour créer/générer de nouveaux modèles à partir de descriptions plus ou moins formalisées (de texte, par exemple) ce qui offre une alternative au mécanisme de production d'UML à partir de texte ;
- pour transformer par exemple des modèles de cahier des charges (ou de spécification) en modèles objet d'analyse par l'utilisation de "motifs d'analyse", ou pour construire des modèles objet de conception à partir des modèles d'analyse en utilisant des "motifs d'architecture" ; plus généralement, on peut envisager d'appliquer l'invention sur n'importe quel type de modèle objet. Il suffit pour cela de disposer d'autres types de motifs et pas seulement de motifs de conception.
- pour transformer des modèles (par exemple, des modèles non-objet en modèles objet ou du LDS en UML ou inversement) ; et
- pour fabriquer des traducteurs de langage (par exemple transformer du COBOL en C ou du C en Java, etc.) car un langage de programmation peut être décrit à l'aide d'un méta-modèle et les modes de ré-écriture d'un langage dans un autre peuvent se traduire sous forme de motifs de conception.

Il convient enfin de noter que l'invention permet également de produire des modèles objet de conception à partir de modèles objet d'analyse en appliquant des "motifs d'architecture". On peut, à cet effet, en appliquant les principes du MDA, construire des modèles de conception en "croisant" des modèles d'analyse avec des modèles d'architecture.

## Revendications

1. Motif de conception (70) adapté à être implémenté informatiquement en une séquence de transformations élémentaires d'un modèle objet.

2. Le motif de conception (70) selon la revendication 1, dans lequel chacune des transformations élémentaires est une modification, une suppression ou une création d'un élément de modélisation du modèle objet.

3. Le motif de conception (70) selon la revendication 1 ou 2, dans lequel le modèle objet est conforme à la notation UML.

4. Le motif de conception (70) selon la revendication 1, 2 ou 3, **caractérisé en ce que** :
- le motif est interprétable par un programme (50) informatique ; et
- le motif est prévu pour déclencher l'exécution par ce programme (50) de la séquence de transformations.

5. Le motif de conception (70) selon la revendication 4, dans lequel le programme (50) comporte un programme d'aide à l'utilisateur.

6. Produit de programme (50) d'ordinateur, par exemple comprenant un programme d'aide à l'utilisateur, prévu pour interpréter le motif de conception (70) selon l'une des revendications 1 à 5.

7. Procédé de transformation d'un modèle objet, comprenant :
- une étape d'accession (E2) au motif de conception (70) selon l'une des revendications 1 à 4 ; et
- une étape d'exécution (E3) de la séquence, prévue par ce motif, de transformations élémentaires d'un modèle objet initial.

8. Le procédé selon la revendication 7, comprenant, préalablement aux étapes de la revendication 7 :
- une étape d'accession au modèle objet initial, celui-ci comprenant plusieurs éléments de modélisation ;
- pour chaque élément de modélisation du modèle objet initial, une étape de recherche d'un stéréotype associé (El); et
- si un stéréotype a été trouvé à l'étape de recherche, une étape de recherche du motif de conception (70) correspondant au stéréotype trouvé.

9. Le procédé selon la revendication 7 ou 8, comprenant, préalablement aux étapes de la revendication 7 :
- une étape de sauvegarde du modèle objet initial.

10. Le procédé selon l'une quelconque des revendications 7 à 9, dans lequel les étapes sont en partie effectuées par un programme d'aide à l'utilisateur.

11. Procédé de génération de code, comprenant :
- les étapes du procédé selon l'une quelconque des revendications 7 à 10 ; et
- une étape de génération d'un code à partir du modèle objet transformé à l'étape d'exécution de la séquence de transformations.

## Revendications modifiées

### Revendications modifiées conformément à la règle 86(2) CBE.

**1.** Motif de conception (70) adapté à être implémenté informatiquement en une séquence de transformations élémentaires d'un modèle objet, **caractérisé en ce que** chacune des transformations élémentaires est une modification, une suppression ou une création d'un élément de modélisation du modèle objet.

**2.** Le motif de conception (70) selon la revendication 1 , dans lequel le modèle objet est conforme à la notation UML.

**3.** Le motif de conception (70) selon la revendication 1, ou 2, **caractérisé en ce que** :
- le motif est interprétable par un programme (50) informatique ; et
- le motif est prévu pour déclencher l'exécution par ce programme (50) de la séquence de transformations.

**4.** Le motif de conception (70) selon la revendication 3, dans lequel le programme (50) comporte un programme d'aide à l'utilisateur.

**5.** Produit de programme (50) d'ordinateur, par exemple comprenant un programme d'aide à l'utilisateur, prévu pour interpréter le motif de conception (70) selon l'une des revendications 1 à 4.

**6.** Procédé de transformation d'un modèle objet, comprenant :
- une étape d'accession (E2) au motif de conception (70) selon l'une des revendications 1 à 3 ; et
- une étape d'exécution (E3) de la séquence, prévue par ce motif, de transformations élémentaires d'un modèle objet initial.

**7.** Le procédé selon la revendication 6, comprenant, préalablement aux étapes de la revendication 6 :
- une étape d'accession au modèle objet initial, celui-ci comprenant plusieurs éléments de modélisation ;
- pour chaque élément de modélisation du modèle objet initial, une étape de recherche d'un stéréotype associé (E1); et
- si un stéréotype a été trouvé à l'étape de recherche, une étape de recherche du motif de conception (70) correspondant au stéréotype trouvé.

**8.** Le procédé selon la revendication 6 ou 7, comprenant, préalablement aux étapes de la revendication 6 :
- une étape de sauvegarde du modèle objet initial.

**9.** Le procédé selon l'une quelconque des revendications 6 à 8, dans lequel les étapes sont en partie effectuées par un programme d'aide à l'utilisateur.

**10.** Procédé de génération de code, comprenant :
- les étapes du procédé selon l'une quelconque des revendications 6 à 9 ; et
- une étape de génération d'un code à partir du modèle objet transformé à l'étape d'exécution de la séquence de transformations.
